# EUROPEAN PATENT SPECIFICATION

(11) **EP 0 552 979 B1**
(45) Date of publication and mention of the grant of the patent: **25.07.2001**
(21) Application number: 93300475.6
(22) Date of filing: 22.01.1993
(51) Int. Cl.: H03M 13/27, H04N 7/00

(54) **Apparatus and method for de-interleaving data**
Gerät und Verfahren zum Entschachteln von Daten
Appareil et méthode pour désentrelacer des données

(30) Priority: 23.01.1992 KR 88692
(43) Date of publication of application: 28.07.1993
(73) Proprietor: Samsung Electronics Co., Ltd., Suwon-city, Kyungki-do 441-370 (KR)
(72) Inventor: Han, Hong Soo, Jangan-Gu, Suwon-City, Kyungki-Do (KR)
(74) Representative: Read, Matthew Charles

(56) References cited:
- EP-A- 0 213 961
- EP-A- 0 222 386
- EP-A- 0 246 767
- EP-A- 0 289 050
- FR-A- 2 637 146
- US-A- 5 063 533

## Description

The present invention relates to a data de-interleaving apparatus for de-interleaving an internally interleaved packet of data bits and to a method of de-interleaving an internally interleaved packet of data bits. The present invention has particular, though not exclusive, application in processing D2 MAC audio signals.

The D2 MAC system, developed in Europe for television broadcasting using satellites, digitises an audio signal and time-division-multiplexes it with a luminance signal and a colour difference signal. However, if a burst error occurs corrupting a continuous train of bits, the error correction capability at the receiver is seriously impaired, compared with the case of random errors independently occurring in individual bits. In order to solve this problem, it has been proposed to interleave the digital audio signal of a D2 MAC signal before transmission.

In a D2 MAC signal, one frame consists of 625 lines, each of which comprises 648 bits. Each line comprises a 6-bit line sync signal, a 99-bit digital audio signal and an analogue video signal occupying the space of 543 bits. Generally, the 99-bit audio signal contains an audio signal and auxiliary data for processing the audio signal. 751 digital audio bits constitute one packet the bits of which are interleaved. Approximately, 7 lines of digital audio signal form one packet. TABLE 1 illustates the interleaving sequence in one packet where interleaving is performed on a bit by bit basis.

**TABLE 1**

| | | | | | | | |
|---|---|---|---|---|---|---|---|
| 1 | 95 | 189 | 283 | 377 | 471 | 565 | 659 |
| 2 | 96 | 190 | 284 | 378 | 472 | 566 | 660 |
| 3 | 97 | 191 | 285 | 379 | 473 | 567 | 661 |
| 4 | 98 | 192 | 286 | 380 | 474 | 568 | . |
| 5 | 99 | 193 | 287 | 381 | 475 | . | . |
| 6 | 100 | 194 | 288 | 382 | . | . | . |
| 7 | 101 | 195 | 289 | . | . | . | 745 |
| 8 | 102 | 196 | . | . | . | 652 | 746 |
| 9 | 103 | . | . | . | 559 | 653 | 747 |
| 10 | . | . | . | 466 | 560 | 654 | 748 |
| . | . | . | 373 | 467 | 561 | 655 | 748 |
| . | . | 280 | 374 | 468 | 562 | 656 | 749 |
| . | 187 | 281 | 375 | 469 | 563 | 657 | 750 |
| 94 | 188 | 282 | 376 | 470 | 564 | 658 | |

One packet of audio data is arranged in the order 1, 2, 3, ..., 93, 94, 95, ..., 750, 751. The interleaving is carried out by re-arranging the data in the horizontal sequence of Table 1. That is the data is re-arranged in the sequence 1, 95, 189, 283, 377, 471, 565, 659, 2, 96, ..., 564, 658 according to a 94-bit interleaving interval. Thus, bits 2 is located eight places after bit 1.

Though errors may occur in the audio data which has been interleaved, burst errors are converted into random errors and the error correction capability of the system is improved. However, until now, there has not been proposed a de-interleaving system for audio data which has been interleaved on a bit-by-bit basis within packets. Thus, the improvement of error correction capability cannot be fully achieved.

US-A-5 063 533 discloses a de-interleaving apparatus in which interleaved data are stored in a NxM RAM. The RAM is read out blockwise column by column in order to obtain de-interleaved data.

EP-A-0 246 767 discloses an asynchronous 3-port FIFO memory arrangement in which a pair of memories is operated such that alternately one memory reads out data while data are written into the other memory.

According to the present invention, there is provided a data de-interleaving apparatus for de-interleaving an internally interleaved packet of data bits, the apparatus comprising: first and second N x 1 bit memories; binary write address generating means arranged to generate write address signals; binary read address generating means arranged to generate read address signals; and switching means for alternately applying the generated write and read address signals to said memories such that when the write address signals are applied to one of said memories, the read address signals are applied to the other of said memories, wherein successive read address identified by said read address signals are separated by a predetermined step greater than one, the step corresponding to the separation in the interleaved packet of temporally successive bits of the packet prior to interleaving.

According to the present invention, there is also provided a method of de-interleaving an internally interleaved packet of data bits, the method comprising the steps of:
generating binary write addresses and storing packets of interleaved data alternately in first and second N x 1 bit memories in dependence on the write addresses;
contemporaneously with the generation of the write addresses, generating binary read addresses and reading the packet of interleaved data from the memory not currently being written to, in dependence on the write addresses, in dependence on the read addresses; wherein successive read addresses identified by said read address signals are separated by a predetermined step greater than one, the step corresponding to the separation in the interleaved packet of temporally successive bits of the packet prior to interleaving.

Preferably, each read address is left shifted by a predetermined number of places, with wrap-around, relative to the contemporaneous write address. More preferably, each read address is left-shifted, with wrap-around, by three places relative to the contemporaneous write address.

When the present invention is applied to D2 MAC signals as discussed above, the write addresses are preferably generated only during counting of the bits of audio data contained each line of a D2 MAC signal.
An embodiment of the present invention will now be described, by way of example, with reference to the accompanying drawings, in which:
Figure 1 is a circuit diagram of one embodiment of a de-interleaving apparatus according to the present invention;
Figure 2 is a circuit diagram of the write address generator shown in Figure 1; and
Figures 3A and 3B are signal timing diagrams for the de-interleaving apparatus.

In one embodiment of the present invention, de-interleaving is performing in such a manner that audio data, in synchronization with a line sync signal and a frame sync signal, is input to be stored in a memory packet by packet and the stored data is read out by intervals of 8 bits.

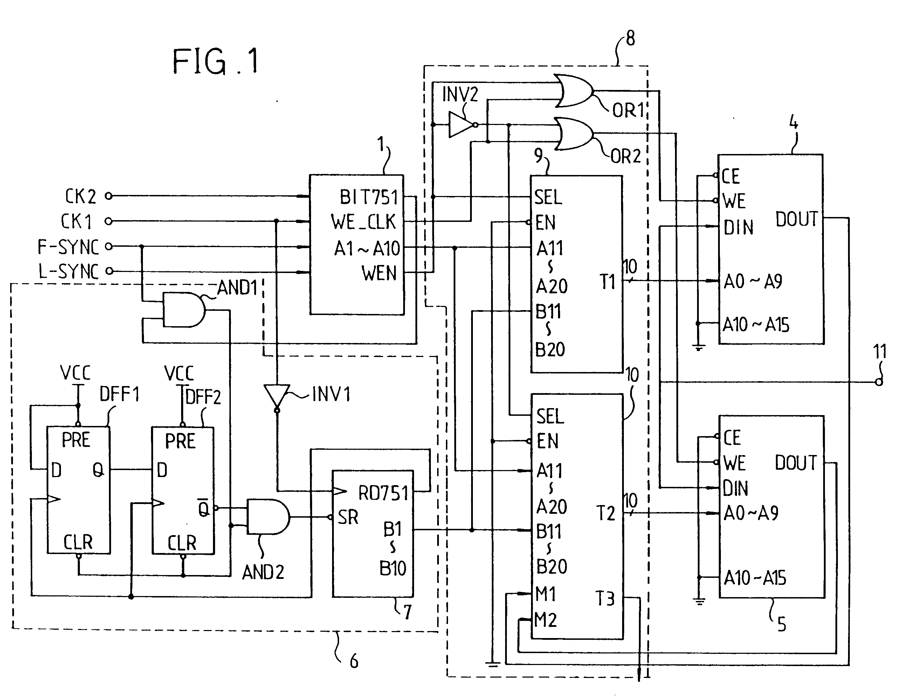

Referring to Figure 1, a de-interleaving apparatus of the present invention comprises a write address generator 1 for receiving a frame sync signal F-SYNC, a line sync signal L-SYNC and clocks CK1 and CK2 and for outputting write-address-related signals WE-CKL, A1 A10 and WEN for storing one packet of audio data in a memory and a 751-bit count signal BIT751, a read address generator 6 for receiving the frame sync signal F-SYNC, the first clock CK1 and the 751-bit count signal BIT751 of the write address generator 1 so as to generate a memory read address, first and second RAMS 4 and 5 each for storing one packet of audio data, and a selector 8 for receiving the output signals of the write address generator 1 and the read address generator 6 and switching the memory read/write addresses for each packet to apply them to first and second RAMs 4 and 5 alternately.

Read address generator 6 comprises a first AND gate AND1 for receiving the frame sync signal F-SYNC and the first clock CK1, a first inverter INV1 for receiving the first clock CK1 and inverting and outputting the clock, a second 751-bit counter 7 for receiving the output signal of the inverter INV1 as a clock signal so as to output a count signal RD751 and address signals B1-B10, a first D-flipflop DFF1 having power supply voltage VCC applied to its data input port D, a second D-flipflop DFF2 having its data input port D coupled to the data output port Q of the first D-flipflop DFF1, and a second AND gate AND2 for logically processing the output signal of first AND gate AND1 and the output signal of second D-flipflop DFF2. D-flipflop DFF1 and DFF2 have power supply voltage VCC applied to their respective preset ports PRE. The output signal of first AND gate AND1 is input into the clear ports CLR of the D-flipflops. The clock input ports of the D-flipflops receive the count signal RD751 of the second 751-bit counter 7.

A selector 8 comprises a first multiplexer 9 having input ports A11-A20 connected to output ports A1-A10 of the write address generator 1, input ports B11-B20 connected to the output ports B1-B10 of the read address generator 6 and a selection port SEL for receiving write enable signal WEN from the write address generator 1, a second multiplexer 10 having input ports A11-A20 connected to output ports A1-A10 of the write address generator 1, input ports B11-B20 connected to output ports B1-B10 of the read address generator 6 and a selection port SEL for receiving the inverted write enable signal WEN from the write address generator 1, a second inverter INV2 for inverting and outputting the write enable signal WEN from the write address generator 1, a first OR gate OR1 for receiving the write enable signal WEN and the clock WE-CLK from the write address generator 1, and a second OR gate OR2 for logically processing the clock WE-CLK from the write address generator 1 and the output signal of the second inverter INV2.

In addition to the input ports of the first multiplexer, second multiplexer 10 further comprises two input ports M1 and M2 which receive the outputs of RAMs 4 and 5, and outputs the received signals through an output port T3 according to the selection signal SEL. Second multiplexer 10 selects signal input port M2, connected to the second RAM, if the selection signal SE is at logic '1'. It selects signal input port M1, connected to first RAM 4, if the selection signal SE is at logic '0'. Enable ports EN of first and second multiplexers 9 and 10 are grounded.

The first RAM 4 is connected by its input ports A0-A9 to an output port T1 of the first multiplexer 9. The output signal of the first OR gate OR1 of the selector 8 is input into the write enable signal port WE of the first RAM. Second RAM 5 is connected by its input ports A0-A9 to an output port T2 of the second multiplexer 10. The output signal of the second OR gate OR2 of the selection 8 is input into the write enable signal port WE of the second RAM. The two RAMs 4 and 5 comprise data input ports DIN and data output ports DOUT. The output signal of the first RAM 4 is input into input port M1 of the second multiplexer 10 and the output signal of the second RAM 5 is input into input port M2 of the second multiplexer 10.

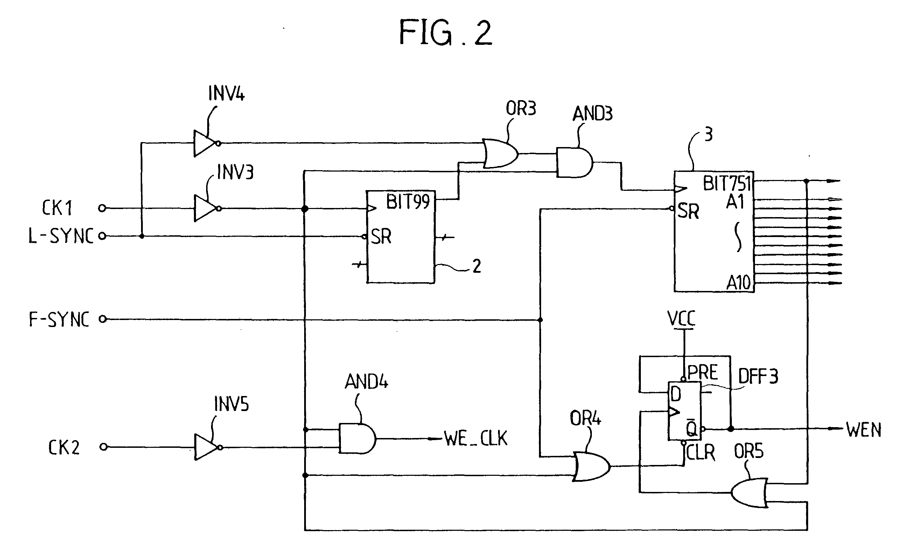

Referring to Figure 2, the write address generator comprises a third inverter INV3 for receiving and inverting the first clock CK, a 99-bit counter 2 for receiving the line sync signal L-SYNC through the reset port SR so as to count the pulses in the output signal of the third inverter INV3, a fourth inverter INV4 for receiving and inverting the line sync signal L-SYNC, a third OR gate OR3 for receiving the output signal of the fourth inverter INV4 and a count signal BIT99 from the 99-bit counter 2, a third AND gate AND3 for logically processing the output signal of the third OR gate OR3 and the output signal of the third inverter INV3, a fifth inverter INV5 for receiving and inverting the second clock CK2, a fourth AND gate AND4 for receiving the output signals of the third inverter INV3 and a fifth inverter INV5 to generate the write enable clock WE-CLK, a first 751-bit counter 3 for receiving the frame sync signal F-SYNC through reset port SR and counting the pulses in the output signal of the third AND gate AND3 and outputting a counting end signal BIT751 and pulse signal A1-A10, a fourth OR gate OR4 for receiving the frame sync signal F-SYNC and the output signal of the third inverter INV3, a fifth OR gate OR5 for receiving the count signal BIT751 from the first 751-bit counter 3 and the output signal from the third inverter INV3, and a third D-flipflop DFF3 in which the power supply voltage VCC is input at the preset port PRE, the output signal of the fourth OR gate OR4 is input at the clear port CLR, and the output signal from data output port Q is fedback to the data input port D. The output signal of the fifth OR gate OR5 is input at the clock port CLK of the third D-flipflop.

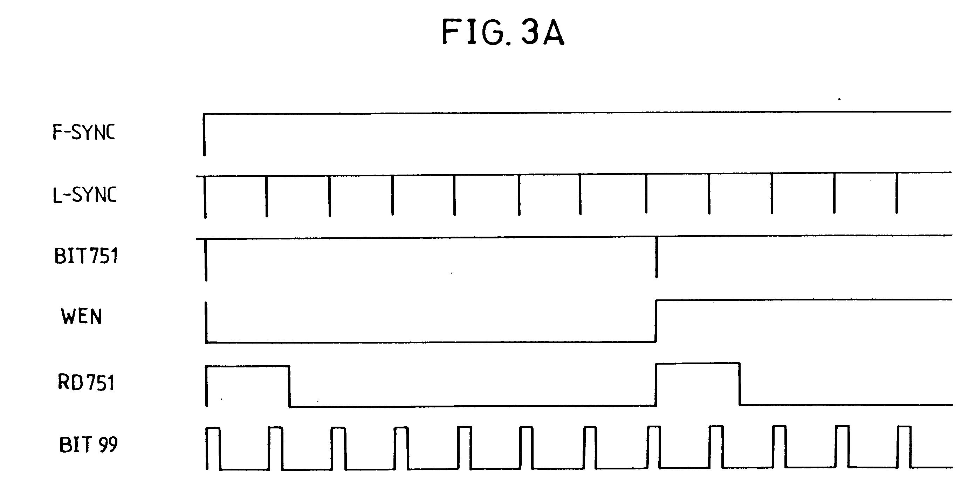

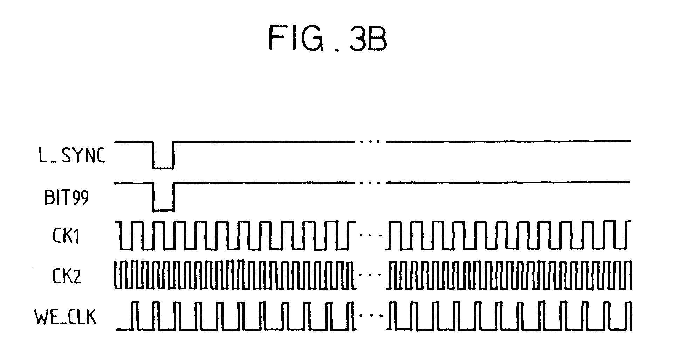

Figures 3A and 3B show the relationships between the signals of the circuits using, as basic clocks, the first clock CK1 having a period corresponding to one bit of a D2 MAC signal and the second clock CK2 having half the period of the first clock. Read enable clock WE-CLK has the same period as the first clock CK1 but has half the high-level pulse width of the first clock CK1.

When the frame sync signal F-SYNC and the line sync signal L-SYNC are input to the apparatus shown in Figure 1, write address generator 1, receiving clocks CK1 and CK2, outputs write-address-related signals using the built-in 99-bit counter 2 and the first 751-bit counter 3. That is, the write address generator produces the write-address-related signals for storing the audio data, contained in the 99-bit area of each D2 MAC line, in the first and second RAMs 4 and 5 in blocks of 751 bits.

The operation of the write address generator 1 will be described below in detail with reference to Figures 2, 3A and 3B.

First and second clocks CK1 and CK2 shown in Figure 3B are inverted by third and fifth inverters INV3 and INV5 and input into the write address generator 1. The write address generator 1 produces new write addresses according to the input of logic '0' pulses in the frame sync signal F-SYNC and the line sync signal L-SYNC. The 99-bit counter 2 counts the first clock CK1, inverted by third inverter INV3, and outputs a logic '1' pulse signal BIT99 during counting. The 99-bit counter 2 is reset by the logic '0' pulse of the line sync signal L-SYNC. THe output signal BIT99 of 99-bit counter 2 is logically summed with the inverted line sync signal and logically multiplied by the inverted first clock. Thus, the first 751-bit counter 3 counts by receiving the inverted first clock as a clock signal. During the counting of the input clocks, the first 751-bit counter 3 generates and outputs memory write addresses through output ports A1-A10. When the 751-bit counting is finished or frame sync signal F-SYNC is input, 751-bit counter 3 is reset and outputs a low-level pulse corresponding to one period of the first clock CK1. When the 751-bit counting is being carried out or the frame sync signal is not input, a logic '1' is output continuously.

The fourth AND gate AND4 receives the inverted first and second signals CK1 and CK2 so as to generate the write enable clock signal WE-CLK shown in Figure 3B. The third D-flipflop DFF3 receives, as a clock, the resultant signal, in which the inverted first clock CK1 and the count signal BIT751 of the first 751-bit counter 3 are logically summed. Thus, the third D-flipflop DFF3 alternately outputs a logic '0' pulse signal and a logic '1' pulse signal while counting to 751 bits.

The first AND gate AND1 of the read address generator 6 receives the frame sync and the count BIT751 signals from the write address generator 1 which are logic '0' pulses, so as to clear the first and second D-flipflops DFF1 and DFF2. Thus, the second 751-bit counter 7 is reset by the output signal of the second AND gate AND2 and counts the first clock CK1, received via the first inverter INV1. Since the second 751-bit counter 7 is reset only by the logic '0' pulse of the frame sync signal F-SYNC and the count signal BIT751 from the write address generator 1, the read address generator 6 generates continuous memory read addresses.

Selector 8 receives the write enable signal WEN from the write address generator 1 and selects the output signals of multiplexers 9 and 10. Specifically, the selector selectively outputs the address signals of the write address generator 1 and the read address generator 6 using the write enable signal WEN and the inverted write enable signal, inverted by inverter INV2.

Since the first RAM 4 uses the output signal of the first OR gate OR1 as its write enable signal WEN, the first RAM stores input data during the logic '0' state of the write enable signal, shown in Figure 3A. Since the second RAM 5 uses the output signal of the second OR gate OR2 as its write enable signal WEN, the second RAM stores input data during the logic '1' state of the write enable signal WEN, output from the write address generator 1.

When audio data is input via data input port 11, first RAM stores the input audio according to the address signals generated by the write address generator 1 and first multiplexer 9. That is, when the output signal of BIT99 of 99-bit counter 2 and count signal BIT751 of first 751-bit counter 3 are both at logic '1' and the write enable signal WEN is at logic '0', the first RAM 4 stores the audio data input via the data input port 11. Therefore, the first RAM 4 stores one packet of 751 bits by storing 99 bits of audio data for every line. While the first RAM 4 stores data, the second RAM 5 outputs one packet of stored audio data according to the address signals generated by the read address generator 6 and the second multiplexer 10. Read address signal input ports B11-B20 of first and second RAMS 4 and 5 are arranged to be left shifted by three places, with wrap-around, with respect to write address signal input ports A11-A20. For instance write address signal input port A14 is arranged to correspond to read address signal input port B11. The read addresses output from multiplexers 9 and 10 are applied to the RAMs 4 or 5 by intervals of 8 bits of interleaved audio data. Accordingly, the apparatus shown Figure 1 de-interleaves the inverleaved audio data using a method for reading stored data.

When one packet of audio data is completely stored, first RAM 4 outputs stored audio data through output port T3 of second multiplexer 10. At the same time, second RAM 5 begins to store audio data input via the input port 11 according to the address signal input via the address output port 12 of second multiplexer 10. When one packet of audio data is stored, second RAM 5 outputs stored audio data through output port T3 of second multiplexer 10 according to the control signal of the selector 8. First RAM 4 stores audio data input via the input port 11 during data output by the second RAM 5. The data write/read operation of first and second RAMs 4 and 5 allows continuous de-interleaving of input audio data.

As described above, the de-interleaving method and apparatus of the present invention receives packets of interleaved D2 MAC audio data and de-interleaves the audio data using a simple memory input/output control, to thereby enhance the error correction capability of the D2 MAC system.

## Claims

1. A data de-interleaving apparatus for de-interleaving an internally interleaved packet of data bits, the apparatus comprising:
first and second N x 1 bit memories (4, 5);
binary write address generating means (1) arranged to generate write address signals;
binary read address generating means (6) arranged to generate read address signals; and
switching means (8) for alternately applying the generated write and read address signals to said memories such that when the write address signals are applied to one of said memories, the read address signals are applied to the other of said memories,
wherein successive read addresses identified by said read address signals are separated by a predetermined step greater than one, the step corresponding to the separation in the interleaved packet of temporally successive bits of the packet prior to interleaving.

2. An apparatus according to claim 1, wherein each read address is left shifted by a predetermined number of places, with wrap-around, relative to the contemporaneous write address identified by said write address signals.

3. An apparatus according to claim 2, wherein each read address is left-shifted, with wrap-around, by three places relative to the contemporaneous write address.

4. A data de-interleaving apparatus for de-interleaving D2-MAC audio data according to claim 1, 2 or 3, wherein the binary write address generating means comprises:
a first counter (2) for counting the bits of audio data contained each line of a D2 MAC signal; and
a second counter (3) for generating write address signals only during counting by the first counter.

5. A method of de-interleaving an internally interleaved packet of data bits, the method comprising the steps of:
generating binary write addresses and storing packets of interleaved data alternately in first and second N x 1 bit memories in dependence on the write addresses;
contemporaneously with the generation of the write addresses, generating binary read addresses and reading the packet of interleaved data from the memory not currently being written to, in dependence on the write addresses, in dependence on the read addresses;
wherein successive read addresses identified by said read address signals are separated by a predetermined step greater than one, the step corresponding to the separation in the interleaved packet of temporally successive bits of the packet prior to interleaving.

6. A method according to claim 5, wherein each read address is left shifted by a predetermined number of places, with wrap-around, relative to the contemporaneous write address.

7. A method according to claim 6, wherein each read address is left-shifted, with. wrap-around, by three places relative to the contemporaneous write address.

8. A method of de-interleaving D2-MAC audio data according to claim 5, 6 or 7, wherein the write addresses are generated only during counting of the bits of audio data contained each line of a D2 MAC signal.

## Patentansprüche

1. Datenentschachtelungsvorrichtung zum Entschachteln von einem intern verschachtelten Paket von Datenbits, wobei die Vorrichtung folgendes aufweist:
erste und zweite N x 1 Bitspeicher (4, 5);
ein binäres Schreibadressenerzeugungsmittel (1), das angeordnet ist, um Schreibadressensignale zu erzeugen;
ein binäres Leseadressenerzeugungsmittel (6), die angeordnet ist, um Leseadressensignale zu erzeugen; und
ein Schaltmittel (8), um die erzeugten Schreib- und Leseadressensignale abwechselnd auf die Speicher anzuwenden, so dass, wenn die Schreibadressensignale auf einen der Speicher angewandt werden, die Leseadressensignale auf den anderen der Speicher angewandt werden,
in der aufeinanderfolgende, von den Leseadressensignalen identifizierte Leseadressen von einem vorbestimmten Schritt größer als 1 getrennt sind, wobei der Schritt der Trennung in dem verschachtelten Paket von zeitlich aufeinanderfolgenden Bits des Pakets vor der Verschachtelung entspricht.

2. Vorrichtung nach Anspruch 1, in der jede Leseadresse um eine vorbestimmte Anzahl von Plätzen mit Bildumlauf relativ zu der gleichzeitigen Schreibadresse, die von den Schreibadressensignalen identifiziert ist, nach links verschoben ist.

3. Vorrichtung nach Anspruch 2, in der jede Leseadresse mit Bildumlauf um drei Plätze relativ zu der gleichzeitigen Schreibadresse nach links verschoben ist.

4. Datenverschachtelungsvorrichtung zum Entschachteln von D2-MAC-Audiodaten nach Anspruch 1, 2 oder 3, in der das binäre Schreibadressenerzeugungsmittel folgendes aufweist:
einen ersten Zähler (2) zum Zählen der Bits von Audiodaten, die in jeder Zeile von einem D2 MAC-Signal enthalten sind; und
einen zweiten Zähler (3) zum Erzeugen von Schreibadressensignalen nur während des Zählens von dem ersten Zähler.

5. Verfahren zum Entschachteln von einem intern verschachtelten Paket von Datenbits, wobei das Verfahren die folgenden Schritte aufweist:
Erzeugen von binären Schreibadressen und Speichern von Paketen von verschachtelten Daten abwechselnd in ersten und zweiten N x 1 Bitspeichern in Abhängigkeit von den Schreibadressen;
gleichzeitig mit der Erzeugung von Schreibadressen, Erzeugen von binären Leseadressen und Lesen des Pakets von verschachtelten Daten von dem Speicher, in den gerade nicht geschrieben wird, in Abhängigkeit von den Schreibadressen, in Abhängigkeit von den Leseadressen;
worin aufeinanderfolgende von den Leseadressensignalen identifizierte Leseadressen von einem vorbestimmten Schritt größer als 1 getrennt sind, wobei der Schritt der Trennung in dem verschachtelten Paket von zeitlich aufeinanderfolgenden Bits des Pakets vor der Verschachtelung entspricht.

6. Verfahren nach Anspruch 5, in dem jede Leseadresse um eine vorbestimmte Anzahl von Plätzen mit Bildumlauf relativ zu der gleichzeitigen Schreibadresse nach links verschoben ist.

7. Verfahren nach Anspruch 6, in dem jede Leseadresse mit Bildumlauf um drei Plätze relativ zu der gleichzeitigen Schreibadresse nach links verschoben ist.

8. Verfahren zum Entschachteln von D2 MAC-Audiodaten nach Anspruch 5, 6 oder 7, in dem die Schreibadressen nur während des Zählens der Bits von Audiodaten erzeugt werden, die in jeder Zeile von einem D2 MAC-Signal enthalten sind.

## Revendications

1. Appareil de désimbrication de données pour désimbriquer un paquet imbriqué intérieurement d'éléments binaires de données, ledit appareil comportant:
des première et deuxième mémoires N x 1 élément binaire (4, 5);
des moyens binaires générateurs d'écriture d'adresse (1) disposés de manière à permettre la génération de signaux d'écriture d'adresse;
des moyens binaires générateurs de lecture d'adresse (6) disposés de manière à permettre la génération de signaux de lecture d'adresse;
des moyens commutateurs (8) pour l'application en alternance des signaux générés d'écriture et de lecture d'adresse auxdites mémoires de façon telle que lorsque les signaux d'adresse de lecture sont appliqués à l'une des mémoires, les signaux de lecture d'adresse sont appliqués à l'autre desdites mémoires,
selon lequel les adresses de lectures successivement identifiées par lesdits signaux de lecture d'adresse se trouvent séparés d'un pas prédéterminé supérieur à l'unité, le pas correspondant à la séparation dans le paquet imbriqué d'éléments binaires temporaires successifs du paquet antérieur à l'imbrication.

2. Appareil selon la revendication 1, suivant lequel chaque adresse de lecture reste déplacée d'un nombre prédéterminé de places, avec bouclage, relativement à l'adresse contemporaine d'écriture identifiée par lesdits signaux d'écriture d'adresse.

3. Appareil selon la revendication 2, suivant lequel chaque adresse de lecture est déplacée à gauche, avec bouclage, de trois places relativement à l'adresse contemporaine d'écriture.

4. Appareil de désimbrication de données pour désimbriquer les données audio MAC D2 selon les revendications 1, 2 ou 3, dont les moyens binaires de génération d'écriture de données comportent:
un premier compteur (2) pour compter les éléments binaires de données audio contenues à chaque ligne du signal MAC D2; et
un deuxième compteur (3) pour générer les signaux d'écriture d'adresse seulement lors du comptage par le premier compteur.

5. Méthode de désimbrication d'un paquet imbriqué intérieurement d'éléments binaires de données, la méthode comportant les phases suivantes:
la génération d'adresses d'écriture binaire et de mise en mémoire de paquets de données imbriquées en alternance en première et deuxième mémoires N x 1 élément binaire en dépendance des adresses d'écriture;
en contemporanéité avec la génération des adresses d'écriture, la génération des adresses binaires d'écriture et de lecture du paquet de données imbriquées à partir de la mémoire non actuellement en cours d'écriture, en dépendance des adresses d'écriture, en dépendance des adresses de lecture;
selon laquelle les adresses successives de lecture identifiées par lesdits signaux d'adresse de lectures sont séparées par une phase prédéterminée supérieure à l'unité, la phase correspondant à la séparation dans le paquet imbriqué d'éléments binaires temporaires successifs du paquet avant l'imbrication.

6. Méthode selon la revendication 5, selon laquelle chaque adresse de lecture est décalée à gauche d'un nombre prédéterminé de positions, avec bouclage, relativement à l'adresse d'écriture contemporaine.

7. Méthode selon la revendication 6, selon laquelle chaque adresse de lecture est décalée à gauche, avec bouclage, de trois positions relativement à l'adresse d'écriture contemporaine.

8. Méthode de désimbrication de données audio MAC D2 selon la revendication 5, 6 ou 7, suivant laquelle les adresses d'écriture ne sont générées que pendant le comptage des éléments binaires de données audio contenues à chaque ligne d'un signal MAC D2.
